# EUROPEAN PATENT APPLICATION

(11) **EP 4 524 179 A1**
(43) Date of publication of application: **19.03.2025**
(21) Application number: 24198589.4
(22) Date of filing: 05.09.2024
(51) Int. Cl.: C08G 73/12, C08K 5/3445, C08L 79/08, C09J 4/00, H01L 23/29, H01L 23/00, C08F 290/06, C08L 71/12, C09D 4/00, G03F 7/00, G03F 7/027, H05K 1/03, H05K 3/02, C08G 59/00, C08G 59/40, C08L 79/04

(54) **CURABLE MALEIMIDE RESIN COMPOSITION, ADHESIVE, PRIMER, CHIP COATING AGENT, AND SEMICONDUCTOR DEVICE**

(30) Priority: 12.09.2023 JP 2023147647
(71) Applicant: Shin-Etsu Chemical Co., Ltd., Tokyo 100-0005 (JP)
(72) Inventor: Tsutsumi, Yoshihiro, Annaka-shi, 3790224 (JP); Ikeda, Tadaharu, Annaka-shi, 3790224 (JP); Iwasaki, Masayuki, Annaka-shi, 3790224 (JP)
(74) Representative: Angerhausen, Christoph

(57) **Abstract**

Provided are a curable maleimide resin composition that can avoid the usage of a problematic solvent, such as NMP among aprotic polar solvents, having a high boiling point and toxicity, can be cured at a relatively low temperature, and provide a cured product having a superior adhesiveness to semiconductor materials. The curable maleimide resin composition contains:
(A) a maleimide compound that has a number average molecular weight of 5,000 to 50,000;
(B) a reaction initiator; and
(C) a silane coupling agent that has one or more epoxy groups in one molecule; and optionally
(D) a diaminotriazine ring-containing imidazole.

## Description

### BACKGROUND OF THE INVENTION

### Field of the invention

The present invention relates to a curable maleimide resin composition, an adhesive, a primer, a chip coating agent, and a semiconductor device.

### Background art

Si (silicon) semiconductors or SiC (silicon carbide) semiconductors are used in the elements that are built in power semiconductor modules.

Meanwhile, SiN (silicon nitride) semiconductors are also widely used for high-performance logic circuits or memories.

Conventionally, curable epoxy resin compositions or curable cyanate resin compositions have been widely used as encapsulation agents for protecting semiconductor elements (See JP-A-2015-48434 and JP-A-2015-93971). However, there has been a problem where when operating a semiconductor device at a high temperature, since semiconductor elements, a base material, and an encapsulation material differ from one another in linear expansion coefficient, stress will be applied to the periphery of the semiconductor device when the device is repeatedly exposed to high and low-temperature environments, and peeling of the encapsulation material is thus likely to occur.

Further, a curable resin component(s) used in an encapsulation material has a low moisture-proof property, and a cured resin product has a high hardness. For this reason, encapsulation materials may not adhere to the semiconductor elements in the encapsulating process of the semiconductor elements, or the materials may be peeled off in the subsequent steps, which in turn raises a problem of reliability degradation as a package.

In order to solve these problems, there are proposed methods of forming a primer layer on semiconductor elements and metal lead frames (See JP-A-2019-176085 and JP-A-2022-148684). Polyimide resin is mainly used for this primer layer. Since polyimide resins are excellent in, for example, heat resistance, flame retardance, mechanical properties, and electrical insulation property, they are widely used as varnishes for interlayer insulation films or surface protective films of semiconductors. There are proposed techniques showing the ways how a polyimide resin in the form of a varnish may be applied to a semiconductor element or the like either directly or via an insulation film, whereafter the resin is cured to form a protective film comprised of polyimide resin, and encapsulation may be further carried out with an encapsulation material of, for example, an epoxy resin (See JP-A-2007-8977 and JP-A-2010-70645).

This polyimide resin varnish generally uses N-methyl-2-pyrrolidone (NMP) as a solvent. While NMP has long been used as an aprotic polar solvent in numerous situations, a stricter restriction is now imposed on the usage thereof mostly and particularly in Europe as the solvent has a high boiling point and is difficult to be removed, on top of which it tends to be readily exposed and is toxic. Further, an alternative material for polyimide resin is desired due to, for example, problems that an extremely high temperature of 250°C or higher is required to cure a polyimide, that a polyimide itself is susceptible to moisture absorption, thus leading to popcorn cracking, and that the quality of the polyimide is not stabilized.

In order to solve these problems, there has been made a proposal to use a composition containing a heat-curable maleimide compound as a primer (See JP-A-2021-25031). Further, in recent years, unplated copper or copper wire is often used for lead frames; and in order to ensure an adhesion force to copper, it is proposed to use a nitrogen atmosphere or an organic peroxide with a low half-life temperature. However, as far as the improvement in reliability of primers is concerned, it is important to have adhesivity not only to metals but also to semiconductor elements; that is, it requires a high level of adhesivity not only to metals and encapsulating materials but also to the semiconductor elements.

### SUMMARY OF THE INVENTION

Thus, it is an object of the present invention to provide a curable maleimide resin composition that can avoid the usage of a problematic solvent such as NMP among aprotic polar solvents, having a high boiling point and toxicity, can be cured at a relatively low temperature, and provide a cured product having a superior adhesiveness to semiconductor materials particularly formed of Si, SiN or SiC. It is also an object of the present invention to provide an adhesive, a substrate material, a primer, and a coating material each using such composition; and a semiconductor device having a cured product of such composition.

In order to solve the above problems, the inventors of the present invention diligently conducted a series of studies, and completed the invention by finding that the curable maleimide resin composition shown below is able to achieve the aforementioned objectives.
<1> A curable maleimide resin composition comprising:
   (A) a maleimide compound that has a number average molecular weight of 5,000 to 50,000 and is represented by a formula (1): 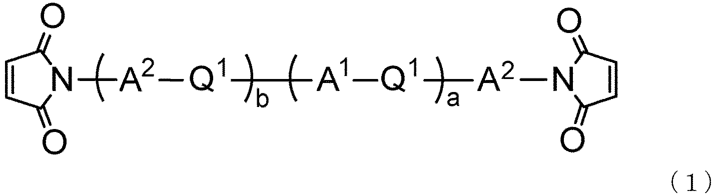
      wherein, in the formula (1), Q¹ is independently a divalent group represented by the following formula: 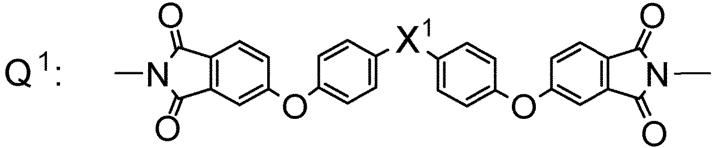 wherein, in the above formula, X¹ is independently a divalent group selected from the following formulae: 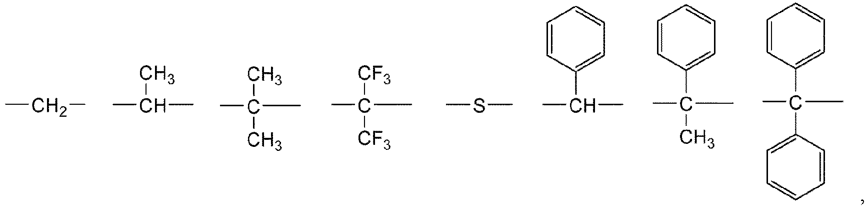 and
      wherein, in the formula (1), a is a number of 0 to 50, b is a number of 1 to 50, each of A¹ and A² independently represents a group expressed by a formula (2) or (3): 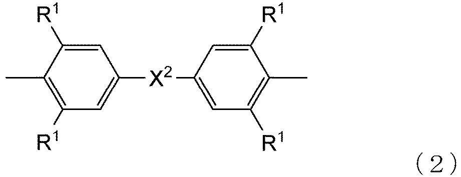 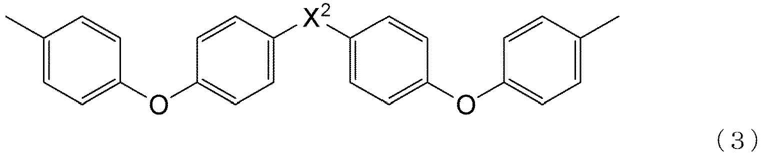 wherein, R¹ in the formula (2) independently represents a hydrogen atom, a chlorine atom, or a substituted or unsubstituted aliphatic hydrocarbon group having 1 to 6 carbon atoms, and X² in the formulae (2) and (3) represents a divalent group selected from groups expressed by the following formulae: 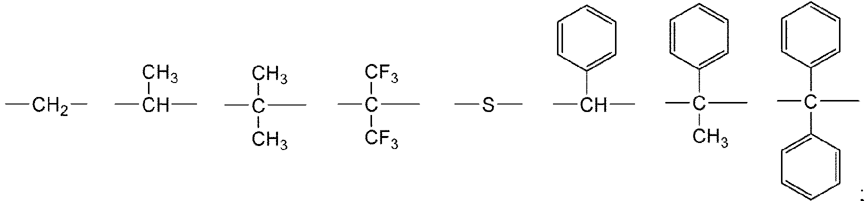
   (B) a reaction initiator; and
   (C) a silane coupling agent having one or more epoxy groups in one molecule.
<2> The curable maleimide resin composition according to <1>, further comprising (D) a diaminotriazine ring-containing imidazole.
<3> The curable maleimide resin composition according to <1> or <2>, further comprising (E) an organic solvent with the proviso that the organic solvent (E) does not comprise N-methylpyrrolidone (NMP).
<4> The curable maleimide resin composition according to any one of <1> to <3>, wherein the reaction initiator (B) is an organic peroxide having a one-hour half-life temperature of 150°C or less.
<5> An adhesive comprised of the curable maleimide resin composition according to any one of <1> to <4>.
<6> A primer comprised of the curable maleimide resin composition according to any one of <1> to <4>.
<7> A chip coating agent comprised of the curable maleimide resin composition according to any one of <1> to <4>.
<8> A semiconductor device having a cured product of the curable maleimide resin composition according to any one of <1> to <4>.

The curable maleimide resin composition of the present invention can avoid the usage of a problematic solvent, such as NMP among aprotic polar solvents, having a high boiling point and toxicity, can be cured at a relatively low temperature, and can provide a cured product having a superior adhesiveness to materials particularly formed of Si, SiN or SiC. Accordingly, the curable maleimide resin composition of the present invention may be suitably used for an adhesive, a primer, and a chip coating agent, as well as a semiconductor device having the cured product of such composition.

### DETAILED DESCRIPTION OF THE INVENTION

The present invention is described in greater detail hereunder.

### (A) Maleimide compound

A component (A) is a maleimide compound that has a number average molecular weight of 5,000 to 50,000 and is represented by the following formula (1): 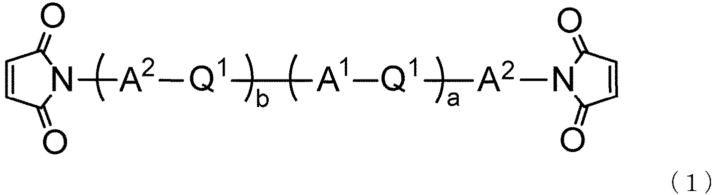 wherein, in the formula (1), Q¹ is independently a divalent group represented by the following formula: 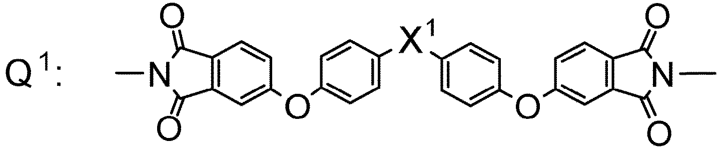 wherein, in the above formula, X¹ is independently a divalent group selected from the following formulae:

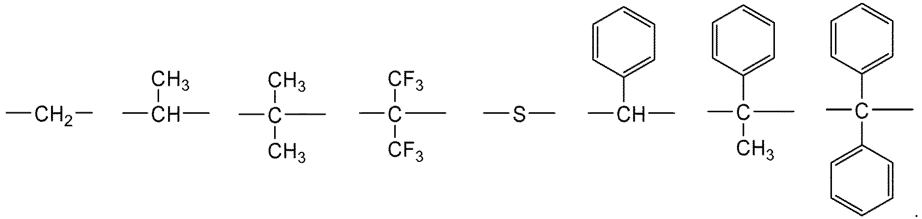

In the formula (1), a is a number of 0 to 50, b is a number of 1 to 50, each of A¹ and A² independently represents a group expressed by a formula (2) or (3): 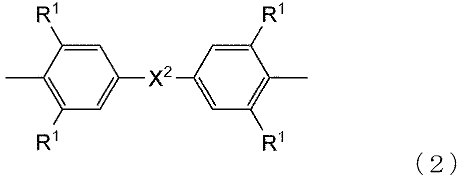 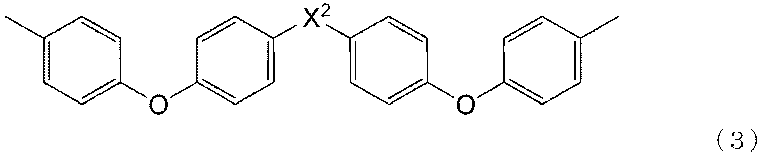 wherein, in the formulae (2) and (3), X² represents a divalent group selected from groups expressed by the following formulae: 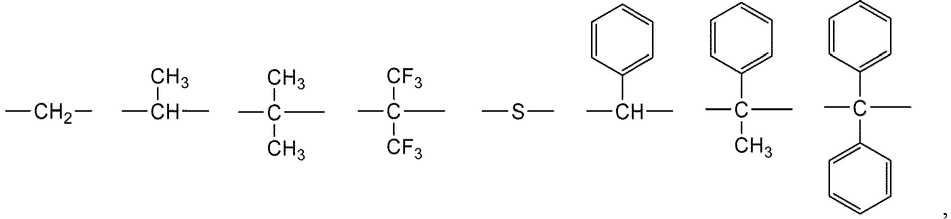 and wherein R¹ in the formula (2) independently represents a hydrogen atom, a chlorine atom, or a substituted or unsubstituted aliphatic hydrocarbon group having 1 to 6 carbon atoms.

In terms of raw material availability, it is preferred that X¹ in the formula (1) be -CH₂- or -C(CH₃)₂-.

In the formula (1), a is a number of 0 to 50, preferably a number of 1 to 40.

In the formula (1), b is a number of 1 to 50, preferably a number of 1 to 40.

In the formula (1), each of A¹ and A² independently represents a group expressed by the above-defined formula (2) or (3).

In terms of raw material availability, it is preferred that X² in the formulae (2) and (3) be -CH₂- or -C(CH₃)₂-.

In the formula (2), R¹ independently represents a hydrogen atom, a chlorine atom, or a substituted or unsubstituted aliphatic hydrocarbon group having 1 to 6 carbon atoms.

As the substituted or unsubstituted aliphatic hydrocarbon group having 1 to 6 carbon atoms, which is represented by R¹ in the formula (2), there may be listed, for example, a methyl group; an ethyl group; an n-propyl group; an isopropyl group; an n-butyl group; a t-butyl group; a cyclohexyl group; and groups obtained by substituting part of or all the hydrogen atoms in any of these groups with, for example, halogen atoms such as F, Cl and Br atoms, where such substituted groups may be exemplified by a trifluoromethyl group. In terms of raw material availability, it is preferred that R¹ be a hydrogen atom or a substituted or unsubstituted aliphatic hydrocarbon group having 1 to 3 carbon atoms.

Further, in the maleimide compound represented by the formula (1), it is preferred that A¹ and A² mutually represent different groups. For example, in the formula (1), it is preferred that A² be a group represented by the formula (3) when A¹ is a group represented by the formula (2); while, for example, it is preferred that A² be a group represented by the formula (2) when A¹ is a group represented by the formula (3). In the maleimide compound represented by the formula (1), A¹ and A² do not simultaneously satisfy the formula (2).

Moreover, a bonding pattern of the repeating units with the repetition numbers a and b in the maleimide compound of the formula (1) may be random or block; in terms of the mechanical strength of a cured product, a block bonding pattern is preferred.

As indicated in the formula (1), the component (A) has a bisphenol structure in its molecule and has an excellent solvent solubility where the component (A) is even soluble in a solvent other than NMP. Further, a bisphenol structure-containing maleimide compound is preferable even from the perspective of raw material availability or the like. Examples of the bisphenol structure in the component (A) include those of bisphenol A, bisphenol F, bisphenol E, and bisphenol AF, of which bisphenol A and bisphenol F are preferred although the structures are not particularly limited to these. Further, in the case of the maleimide compound represented by the formula (1), since a and b are each in the above ranges, a composition containing such maleimide compound will exhibit a favorable balance between solubility into a solvent /film-forming capability when in an uncured state and rigidity/heat resistance of a cured product of such composition.

The number average molecular weight of the maleimide compound as the component (A) is 5,000 to 50,000, preferably 7,000 to 40,000, more preferably 8,000 to 20,000. The number average molecular weight within these ranges allows the maleimide compound as the component (A) to be stably dissolved in a solvent, ensure wettability to a base material, and make the un-cured film less likely to, for example, crack, thus resulting in a favorable film.

Here, the number average molecular weight mentioned as used herein refers to a number average molecular weight that is measured by gel permeation chromatography (GPC) under the following measurement conditions, using polystyrene as a reference substance.
[GPC measurement conditions]
Developing solvent: Tetrahydrofuran
Flow rate: 0.35 mL/min
Detector: Differential refractive index detector (RI)
Column: TSK-GEL H type (by Tosoh Corporation)
Column temperature: 40°C
Sample injection volume: 5 µL (THF solution with a concentration of 0.2% by mass)

The maleimide compound as the component (A) which is represented by the formula (1) can, for example, be produced by a method disclosed in JP-A-2021-017485.

As for the maleimide compound as the component (A), one kind thereof may be used alone, or two or more kinds thereof may be used in combination.

Further, the component (A) is preferably contained in the curable maleimide resin composition of the present invention (or in the curable maleimide resin composition of the present invention excluding a later-described organic solvent (E), if the composition contains such organic solvent (E)) by an amount of 70 to 99.9% by mass, more preferably 80 to 99.5% by mass, even more preferably 85 to 99.0% by mass.

### (B) Reaction initiator

A reaction initiator as a component (B) is added to initiate and promote a cross-linking reaction of the maleimide compound as the component (A), and a reaction between the maleimide groups in the component (A) and reactive groups capable of reacting with them.

There are no particular restrictions on the component (B) so long as it is capable of promoting a cross-linking reaction; in terms of improving productivity, preferred are a thermal radical polymerization initiator and/or a photopolymerization initiator as the composition can be readily cured within a short period of time if using these reaction initiators. If using a thermal radical polymerization initiator as the component (B), the curable maleimide resin composition of the present invention cures at a relatively low temperature (e.g., a temperature lower than 220°C); if using a photopolymerization initiator as the component (B), the composition of the invention cures when irradiated with lights. Here, the component (B) does not include a later-described diaminotriazine ring-containing imidazole (D).

Typical examples of the thermal radical polymerization initiator include organic peroxides, specific examples of which may include dicumyl peroxide, t-butyl peroxybenzoate, t-amyl peroxybenzoate, dibenzoyl peroxide, dilauroyl peroxide, 2,5-dimethyl-2,5-di(t-butylperoxy)hexane, 1,1-di(t-butylperoxy)cyclohexane, di-t-butylperoxide, dibenzoyl peroxide, and 1,6-bis(t-butylperoxycarbonyloxy)hexane.

There are no particular restrictions on the photopolymerization initiator so long as it is capable of initiating a reaction with lights. Examples of the photopolymerization initiator may include aromatic ketones such as 2-benzyl-2-dimethylamino-1-(4-morpholinophenyl)-1-butanone, 2,2-dimethoxy-1,2-diphenylethan-1-one, 1-hydroxy-cyclohexyl-phenyl-ketone, 2-methyl-1-(4-(methylthio)phenyl)-2-morpholino-1-propanone, 2,4-diethylthioxanthone, 2-ethylanthraquinone, and phenanthrenequinone; a benzyl derivative such as benzyl dimethyl ketal; 2,4,5-triarylimidazole dimers such as 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-phenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer, and 2-(2,4-dimethoxyphenyl)-4,5-diphenylimidazole dimer; acridine derivatives such as 9-phenylacridine and 1,7-bis(9,9'-acridinyl)heptane; bisacylphosphine oxides such as bis(2,6-dimethoxybenzoyl)-2,4,4-trimethyl-pentylphosphine oxide and bis(2,4,6-trimethylbenzoyl)-phenylphosphine oxide; alkylphenone-based compounds such as 1-hydroxy-cyclohexyl-phenyl-ketone, 2-benzyl-2-dimethylamino-1-(4-morpholinophenyl)-butanone-1, and 2-(dimethylamino)-2-[(4-methylphenyl)methyl]-1-[4-(4-morpholinyl)phenyl]-1-butanone; an acylphosphine oxide-based compound such as 2,4,6-trimethylbenzoyl-diphenyl-phosphine oxide; and a benzophenone compound.

The reaction initiator is preferably contained in an amount of 0.05 to 10 parts by mass, more preferably 0.1 to 5 parts by mass, per 100 parts by mass of the component (A). Further, if a later-described further heat-curable resin is to be added to the composition, it is preferred that the reaction initiator be contained in an amount of 0.05 to 10 parts by mass, particularly preferably 0.1 to 5 parts by mass, per 100 parts by mass of a sum total of the component (A) and such further heat-curable resin component. It is not preferable if the amount of the reaction initiator is out of the range of 0.05 to 10 parts by mass per 100 parts by mass of the component (A), because curing may take place either extremely slowly or quickly at the time of molding. Moreover, the cured product obtained may exhibit a poor balance between heat resistance and moisture resistance.

Here, as for the reaction initiator, one kind thereof may be used alone, or two or more kinds thereof may be used in combination.

### (C) Silane coupling agent

The silane coupling agent of the component (C) has one or more epoxy groups in one molecule, and is preferably represented by the following general formula (4):

R²_{d}Si(OR³)_{4-d} (4),

wherein, in formula (4), R² is independently a monovalent hydrocarbon group having an epoxy group or a group selected from alkyl groups having 1 to 6 carbon atoms, with the proviso that at least one R² is a monovalent hydrocarbon group having an epoxy group. R³ is independently an alkyl group having 1 to 6 carbon atoms, and d is 1, 2, or 3.

The monovalent hydrocarbon group having the epoxy group is preferably a monovalent hydrocarbon group having 3 to 20 carbon atoms and having an epoxy group, and more preferably a group selected from a 3-glycidoxypropyl group, an 8-glycidoxyoctyl group, and a 2-(3,4-epoxycyclohexyl)ethyl group.

Examples of the alkyl group having 1 to 6 carbon atoms include a methyl group, an ethyl group, a propyl group, a butyl group, a pentyl group, and a hexyl group. It is preferred that the alkyl group having 1 to 6 carbon atoms be a methyl group or an ethyl group.

The silane coupling agent of component (C) has one or more epoxy groups in each molecule, which improves adhesion to semiconductor elements of, for example, Si, SiN or SiC.

R³ is independently an alkyl group having 1 to 6 carbon atoms, preferably 1 to 4 carbon atoms, such as a methyl group, an ethyl group, a propyl group, a butyl group, a pentyl group or a hexyl group; specific examples thereof include a methyl group, an ethyl group, a propyl group and a butyl group. It is particularly preferred that R³ be a methyl group or an ethyl group. d is 1, 2 or 3 among which it is particularly preferred that d be 1.

Specific examples of the component (C) include KBM-403, KBE-403, KBM-303, KBM-4803, KBM-402 (all manufactured by Shin-Etsu Chemical Co., Ltd.), and hydrolysates thereof.

The amount of the component (C) to be blended thereinto is preferably 0.2 to 4.5 parts by mass, and more preferably 0.5 to 2.5 parts by mass, per 100 parts by mass of the component (A). If the amount of the component (C) is less than 0.2 parts by mass, sufficient adhesion force will not be exhibited, and if it exceeds 4.5 parts by mass, not only will voids be more likely to occur during molding of the composition, but the strength of the molded product will also be more likely to decrease.

The composition of the present invention can also be further formulated with the following ingredients as necessary.

### (D) Diaminotriazine ring-containing imidazole

In the present invention, there may further be added a diaminotriazine ring-containing imidazole as a component (D). Particularly, diaminotriazine rings are effective for improving an adhesion force to a metal as typified by copper. Further, the presence of imidazole promotes polymerization of maleimide, and is also effective for imparting heat resistance. There are no particular restrictions on the component (D) so long as it is an imidazole that contains a diaminotriazine ring.

Specific examples thereof include 2,4-diamino-6-[2-(2-methyl-imidazolyl)-ethyl-1,3,5-triazine (2MZ-A by SHIKOKU KASEI HOLDINGS CORPORATION), 2,4-diamino-6-[2-(2-undecyl-1-imidazolyl)ethyl]-1,3,5-triazine (C11Z-A by SHIKOKU KASEI HOLDINGS CORPORATION), 2,4-diamino-6-[2-(4-methyl-1-imidazolyl)ethyl-1,3,5-triazine (2E4MZ-A by SHIKOKU KASEI HOLDINGS CORPORATION), and 2,4-diamino-6-[2-(2-methyl-1-imidazolyl)ethyl-1,3,5-triazine isocyanuric acid adduct (2MA-OK by SHIKOKU KASEI HOLDINGS CORPORATION).

The component (D) is preferably contained in an amount of 0.05 to 5 parts by mass, more preferably 0.1 to 2 parts by mass, per 100 parts by mass of the component (A). The component (D) in an amount of 0.05 to 5 parts by mass per 100 parts by mass of the component (A) achieves an advantageous effect of improving adhesion force and results in favorable dispersibility, and it also prevents poor appearance and does not result in a deteriorated reliability.

### (E) Organic solvent

The composition of the present invention may further contain an organic solvent as a component (E). There are no restrictions on the type of such organic solvent as the component (E) so long as the component (E) is capable of dissolving the component (A); in view of environmental burden, N-methyl-2-pyrrolidone (NMP) shall be excluded from its candidate. Here, the expression "the component (E) is capable of dissolving the component (A)" refers to a condition in which one cannot visually recognize any undissolved residues of the component (A) at 25°C when a solution of 25% by mass of the component (A) with the component (E) as the solvent was prepared. The composition to which such organic solvent is added may be suitably used as a varnish or a primer.

Examples of the organic solvent to be used as the component (E) include general organic solvents such as methyl ethyl ketone (MEK), cyclohexanone, ethyl acetate, tetrahydrofuran (THF), isopropanol (IPA), xylene, toluene, and anisole. Any one of these organic solvents may be used alone, or two or more kinds of them may be used in combination.

If the composition of the present invention is used as a primer, the organic solvent as the component (E) is preferably cyclohexanone, xylene, anisole or the like.

In terms of solubility of the component (A), the organic solvent as the component (E) is preferably an organic solvent such as anisole, xylene, toluene, or cyclohexanone. Meanwhile, due to a high boiling point and toxicity, it is preferred not to use the above-mentioned NMP, dimethylsulfoxide (DMSO), or dimethylformamide (DMF) or any analogue thereof as an aprotic polar solvent. Unlike the conventional composition containing a polyimide compound that can only be dissolved in an aprotic polar solvent, the composition of the present invention has an advantage of not having to use these aprotic polar solvents.

The component (E) is preferably contained in an amount of 100 to 800 parts by mass, more preferably 150 to 700 parts by mass, per 100 parts by mass of the component (A).

### Further additives

Various additives may be added to the curable maleimide resin composition of the present invention to the extent that the advantageous effects of the present invention are not impaired. For example, in order to improve resin properties, there may be added, for example, a thermosetting resin such as an acrylic resin, an organopolysiloxane, a silicone oil, a thermoplastic resin, a thermoplastic elastomer, an organic synthetic rubber, a light stabilizer, a polymerization inhibitor, a flame retardant, a pigment, a dye, and an adhesion aid other than the silane coupling agent. Further, in order to improve electric properties, there may also be added an ion-trapping agent or the like. Furthermore, in order to improve dielectric properties, there may also be added a fluorine-containing material or the like. In order to adjust the respective coefficients of thermal expansion (CTE), an inorganic filler such as silica may also be added.

The curable maleimide resin composition of the present invention can be produced by mixing the components (A), (B), (C), (D), (E) as well as further additives.

The curable maleimide resin composition of the present invention can be used as an adhesive, a primer, a chip coating agent, a coating material for a semiconductor device, a buffer coat, and redistribution layer. No particular restrictions are imposed on how it is used and its use style.

Usage examples are shown below; however, they shall not be limited to the examples described hereunder.

For example, after applying the curable maleimide resin composition containing the components (A), (B) and (C), or the curable maleimide resin composition further containing (D) and/or (E), to a base material (for example, metal lead frames such as silver-plated lead frames and copper lead frames), by performing heating at a temperature of normally not lower than 80°C, preferably not lower than 100°C, for 0.5 to 5 hours, the organic solvent will be removed. Further, a strong maleimide film with a flat surface can be formed by heating the base material at a temperature of not lower than 130°C, preferably not lower than 150°C, for 0.5 to 10 hours if the composition is a heat-curable type; or by irradiating the base material with a UV light of 365 nm if the composition is of a photo-curable type.

In general, while a polyimide-containing composition requires 150°C or higher for drying and 220°C or higher for heat curing, the curable maleimide resin composition of the present invention does not require such a kind of high temperature condition(s). Specifically, the removal of the organic solvent can be carried out at a temperature of not higher than 150°C, and heat curing (film formation) can take place at a temperature of not higher than 200°C.

In order to efficiently remove the organic solvent in the composition and effectively promote the reaction of the resin, the curing temperature may be raised in a stepwise manner in certain cases, or heating may be performed after the composition was photo-cured for the purpose of completing the curing. The cured product (film) obtained by curing the composition of the present invention is superior in mechanical properties, heat resistance, relative permittivity, dielectric tangent, moisture resistance, and adhesiveness. Thus, the cured product of the present invention can, for example, be utilized as an adhesive for a semiconductor element and a lead frame; a primer used between a semiconductor encapsulation material and a lead frame; a chip coating agent (passivation film) for coating the surface of a semiconductor element; a junction protective film for use in junctions of diodes, transistor and the like; an α-ray shielding film for VLSI; an interlayer insulation film; and a conformal coating for a printed circuit board.

Examples of a coating method include those employing a spin coater, a slit coater, a sprayer, a dip coater, and a bar coater; there are no particular restrictions on such methods.

After forming the cured product (film), by molding an epoxy resin molding material for semiconductor encapsulation on such cured product (film), an adhesiveness between the epoxy resin molding material for semiconductor encapsulation and the semiconductor device or the base material can be improved. The resultant semiconductor device obtained in this way exhibits no cracks in the epoxy resin molding material for semiconductor encapsulation and no peeling of such molding material from the base material in a solder reflow process performed after absorbing moisture, which therefore makes the semiconductor device highly reliable.

In such case, as the epoxy resin molding material for semiconductor encapsulation, there may be employed a known epoxy resin composition for semiconductor encapsulation that contains, for example, an epoxy resin having at least two epoxy groups per molecule; a phenolic resin; a curing agent for an epoxy resin, such as an acid anhydride; and/or an inorganic filler. As such known epoxy resin composition, there may be used a commercially available one.

### WORKING EXAMPLES

The present invention is described in detail hereunder with reference to working and comparative examples; however, the invention shall not be limited to the following working examples. Here, in the working and comparative examples, "room temperature" means 25°C.

Components used in the working and comparative examples are shown below. Here, a number average molecular weight (Mn) mentioned hereunder refers to a value that is measured by gel permeation chromatography (GPC) under the following measurement conditions, using polystyrene as a reference substance.
[GPC measurement conditions]
Developing solvent: Tetrahydrofuran
Flow rate: 0.35 mL/min
Detector: Differential refractive index detector (RI)
Column: TSK-GEL H type (by Tosoh Corporation)Column temperature: 40°C
Sample injection volume: 5 µL (THF solution with a concentration of 0.2% by mass)

### (A) Maleimide compound

### [Synthesis example 1]

Here, 65.06 g (0.125 mol) of 2,2-bis[4-(2,3-dicarboxyphenoxy)phenyl]propane dianhydride, 61.59 g (0.150 mol) of 2,2-bis[4-(4-aminophenoxy)phenyl]propane, and 250 g of anisole were added to a 1L glass four-necked flask equipped with a stirrer, a Dean-Stark tube, a cooling condenser and a thermometer, followed by stirring them at 80°C for three hours to synthesize an amic acid. Next, the temperature was directly raised to 150°C, and stirring was performed for another two hours while distilling away water produced as a by-product, thereby producing a diamine compound with each end being blocked with an amino group (this type of diamine compound is also referred to simply as "diamine compound" hereunder).

After cooling the flask, containing the resultant diamine compound solution, to room temperature, 4.39 g (0.055 mol) of maleic anhydride was added thereto, followed by performing stirring at 80°C for three hours to synthesize a maleamic acid. Next, the temperature was directly raised to 150°C, and stirring was performed for another two hours while distilling away water produced as a by-product, thereby obtaining a varnish of an aromatic bismaleimide compound represented by the following formula (A-1): 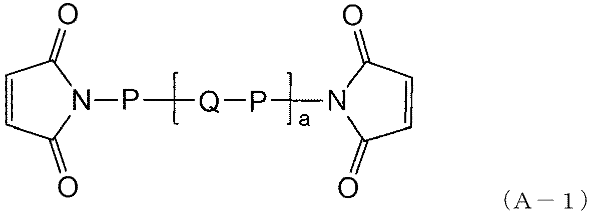 wherein, in the formula (A-1), a ≈ 8 (average value), and P and Q are independently and respectively divalent groups represented by the following formulae:

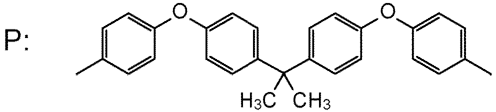

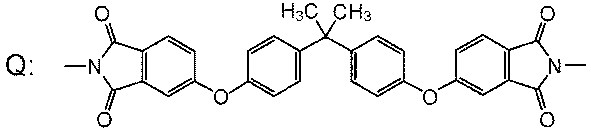

Here, the number average molecular weight (Mn) of the aromatic bismaleimide compound was 12,000. Anisole was further added thereto so that the non-volatile content in the varnish would be in an amount of 17% by mass.

### [Synthesis example 2]

Here, 65.06 g (0.125 mol) of 2,2-bis[4-(2,3-dicarboxyphenoxy)phenyl]propane dianhydride, 35.26 g (0.115 mol) of 4,4-methylenebis(2,6-diethylaniline), and 250 g of anisole were added to a 1L glass four-necked flask equipped with a stirrer, a Dean-Stark tube, a cooling condenser and a thermometer, followed by stirring them at 80°C for three hours to synthesize an amic acid. Next, the temperature was directly raised to 150°C, and stirring was performed for another two hours while distilling away water produced as a by-product, thereby synthesizing a copolymer.

Later, 7.05 g (0.015 mol) of 2,2-bis[4-(4-aminophenoxy)phenyl]propane was added to the copolymer solution-containing flask that had been cooled to room temperature, followed by performing stirring at 80°C for three hours to synthesize an amic acid. Next, the temperature was directly raised to 150°C, and stirring was performed for another two hours while distilling away water produced as a by-product, thereby synthesizing a diamine compound.

After cooling the flask, containing the resultant diamine compound solution, to room temperature, 1.45 g (0.015 mol) of maleic anhydride was added thereto, followed by performing stirring at 80°C for three hours to synthesize a maleamic acid. Next, the temperature was directly raised to 150°C, and stirring was performed for another two hours while distilling away water produced as a by-product, thereby obtaining a varnish of an aromatic bismaleimide compound represented by the following formula (A-2): 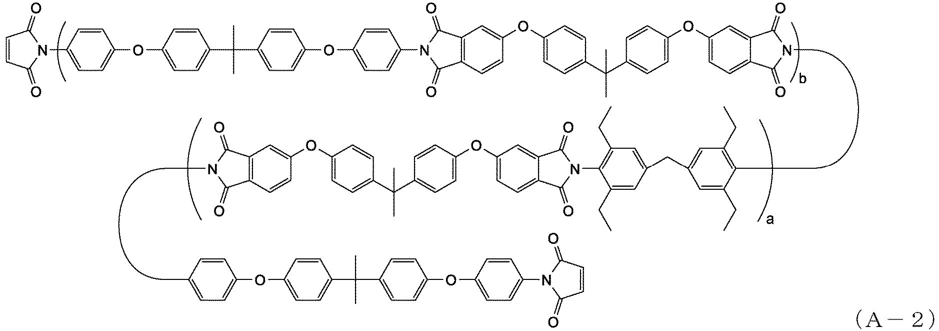 wherein a ≈ 8, b ≈ 1 (average value).

Here, the number average molecular weight (Mn) of the aromatic bismaleimide compound was 15,500. Anisole was further added thereto so that the non-volatile content in the varnish would be in an amount of 17% by mass.

### Other maleimide compounds (for use in comparative examples)

(A-3): Bismaleimide compound represented by the following formula (BMI-5000, Mn: 8,000 by Designer Molecules Inc.): 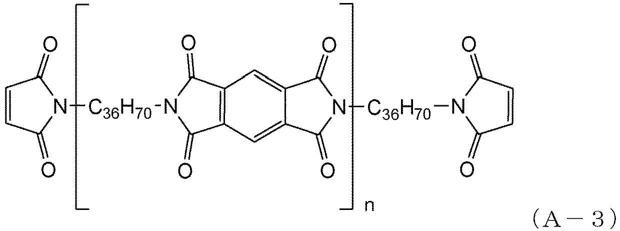 wherein -C₃₆H₇₀- represents a dimer acid frame-derived hydrocarbon group and n ≈ 8 (average value)
(A-4): 4,4'-diphenylmethanebismaleimide (BMI-1000, Mn: 410 by Daiwakasei Industry Co., LTD.)

### (B) Reaction initiator

(B-1): Dicumylperoxide (Perkadox BC-FF by KAYAKU NOURYON CORPORATION, one-hour half-life temperature 132°C)
(B-2): 1,6-bis(t-butylperoxycarbonyloxy)hexane (Kayalene 6-70 by KAYAKU NOURYON CORPORATION, one-hour half-life temperature 117°C)

### (C) Silane coupling agent

(C-1) 2-(3,4-epoxycyclohexyl)ethyltrimethoxysilane (KBM-303, Shin-Etsu Chemical Co., Ltd.)
(C-2) 3-glycidoxypropyltriethoxysilane (KBE-403, Shin-Etsu Chemical Co., Ltd.)
(C-3) Hydrolysate of (C-1) 2-(3,4-epoxycyclohexyl)ethyltrimethoxysilane (component (C-1):water = 4:1 (mass ratio) mixed at 25°C for 12 hours)
(C-4) N-phenyl-3-aminopropyltrimethoxysilane (KBM-573, Shin-Etsu Chemical Co., Ltd., for use in comparative example)
(C-5) 3-methacryloxypropyltrimethoxysilane (KBM-503, Shin-Etsu Chemical Co., Ltd., for use in comparative example)

### (D) Diaminotriazine ring-containing imidazole

(D-1): 2,4-diamino-6-[2-(4-methyl-1-imidazolyl]-ethyl-1,3,5-triazine (2E4MZ-A by SHIKOKU KASEI HOLDINGS CORPORATION)

### Polyimide for use in comparative example

A polyamic acid varnish (KJR-655 by Shin-Etsu Chemical Co., Ltd., varnish using NMP, non-volatile content 15% by mass) was directly used.

### (Formulation examples 1 to 16, working examples 1 to 8, comparative examples 1 to 13)

The components were mixed at the compounding ratios shown in Table 1 to prepare a varnish of a curable maleimide resin composition. Here, in each formulation, anisole was added so that the component (A) would be in an amount of 16.7% by mass, and the component (A) was completely dissolved.

### <Adhesion force and failure mode>

The varnish of the composition obtained in each of the formulation examples 1 to 16 was sprayed to apply the varnish onto a sample of Si, SiN, or SiC cut into a size of 20 mm × 20 mm. The composition was then cured under the curing conditions shown in Table 2 or 3 to form a cured film (primer).

An epoxy resin molding material for semiconductor encapsulation KMC-2284 (by Shin-Etsu Chemical Co., Ltd.) was cured on top of the cured film at a pressure of 6.9 MPa and a temperature of 175°C for 120 sec to mold it into the shape of a cylinder having a base area of 10 mm² and a height of 3 mm. Next, post curing was performed at 180°C for four hours to obtain a test piece, and a versatile-type bond tester (DAGE SERIES 4000 by Nordson DAGE) was then used to measure an adhesion force of such test piece at 25°C at a rate of 0.2 mm/sec.

The results of the adhesion force measurement were rated as failure modes using the symbols ○, △, and × respectively indicating:
○: Semiconductor element was broken;
△: Encapsulant on the semiconductor element underwent cohesive failure; and
×: Interfacial peeling of the encapsulant from the semiconductor element was observed.

These criteria for adhesive favorability, pertaining to the failure modes, were ranked by the favorite order of ○ > △ > ×.

These measurement results are shown in Tables 2 and 3. Further, curing conditions A to C are specifically defined as follows.
Curing condition A: Curing at 110°C for 30 min + Curing at 180°C for 2 hours
Curing condition B: Curing at 110°C for 30 min + Curing at 220°C for 2 hours
Curing condition C: Curing at 150°C for 1 hour + Curing at 200°C for 1 hour + Curing at 250°C for 4 hours

Here, as for the result of the comparative example 1, the example is one in which adhesion forces were measured without using a primer (varnish of composition), and therefore curing condition of this comparative example was omitted in the table.

**Table 1**

| Composition formulation table (parts by mass) | | | Formulation Examples | | | | | | | | |
|---|---|---|---|---|---|---|---|---|---|---|---|
| | | | 1 | 2 | 3 | 4 | 5 | 6 | 7 | 8 | 9 |
| (A) | A-1 | A-1 | 100.0 | 100.0 | 100.0 | 100.0 | 100.0 | 100.0 | | 100.0 | 100.0 |
| | A-2 | A-2 | | | | | | | 100.0 | | |
| | BMI-5000 | A-3 | | | | | | | | | |
| | BMI-1000 | A-4 | | | | | | | | | |
| (B) | Perkadox BC-FF | B-1 | 2.0 | 2.0 | | 2.0 | 2.0 | 2.0 | 2.0 | 2.0 | 2.0 |
| | Kayalene 6-70 | B-2 | | | 2.0 | | | | | | |
| (C) | KBM-303 | C-1 | 0.5 | | 0.5 | 0.2 | 2.5 | 0.5 | 0.5 | | |
| | KBE-403 | C-2 | | 0.5 | | | | | | | |
| | Hydrolysate of the component (C-1) | C-3 | | | | | | | | 0.5 | |
| | KBM-573 | C-4 | | | | | | | | | |
| | KBM-503 | C-5 | | | | | | | | | |
| (D) | 2E4MZ-A | D-1 | | | | | | 10 | | | |

| Composition formulation table (parts by mass) | | | Formulation Examples | | | | | | | |
|---|---|---|---|---|---|---|---|---|---|---|
| | | | 10 | 11 | 12 | 13 | 14 | 15 | 16 | 17 |
| (A) | A-1 | A-1 | 100.0 | 100.0 | 100.0 | 100.0 | | | | |
| | A-2 | A-2 | | | | | | | | |
| | BMI-5000 | A-3 | | | | | 100.0 | 100.0 | | |
| | BMI-1000 | A-4 | | | | | | | 100.0 | 100.0 |
| (B) | Perkadox BC-FF | B-1 | 2.0 | 2.0 | 2.0 | 2.0 | 2.0 | 2.0 | 2.0 | 2.0 |
| | Kayalene 6-70 | B-2 | | | | | | | | |
| (C) | KBM-303 | C-1 | | | | | | 0.5 | | 0.5 |
| | KBE-403 | C-2 | | | | | | | | |
| | Hydrolysate of the component (C-1) | C-3 | | | | | | | | |
| | KBM-573 | C-4 | 0.5 | | | | | | | |
| | KBM-503 | C-5 | | 0.5 | | 0.5 | | | | |
| (D) | 2E4MZ-A | D-1 | | | 1.0 | 1.0 | | | | |

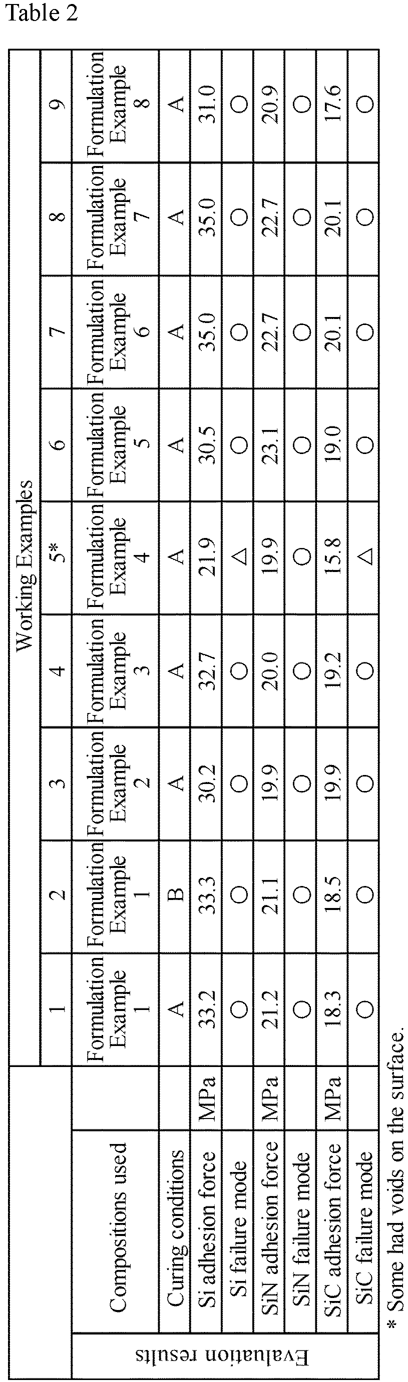

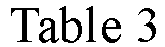

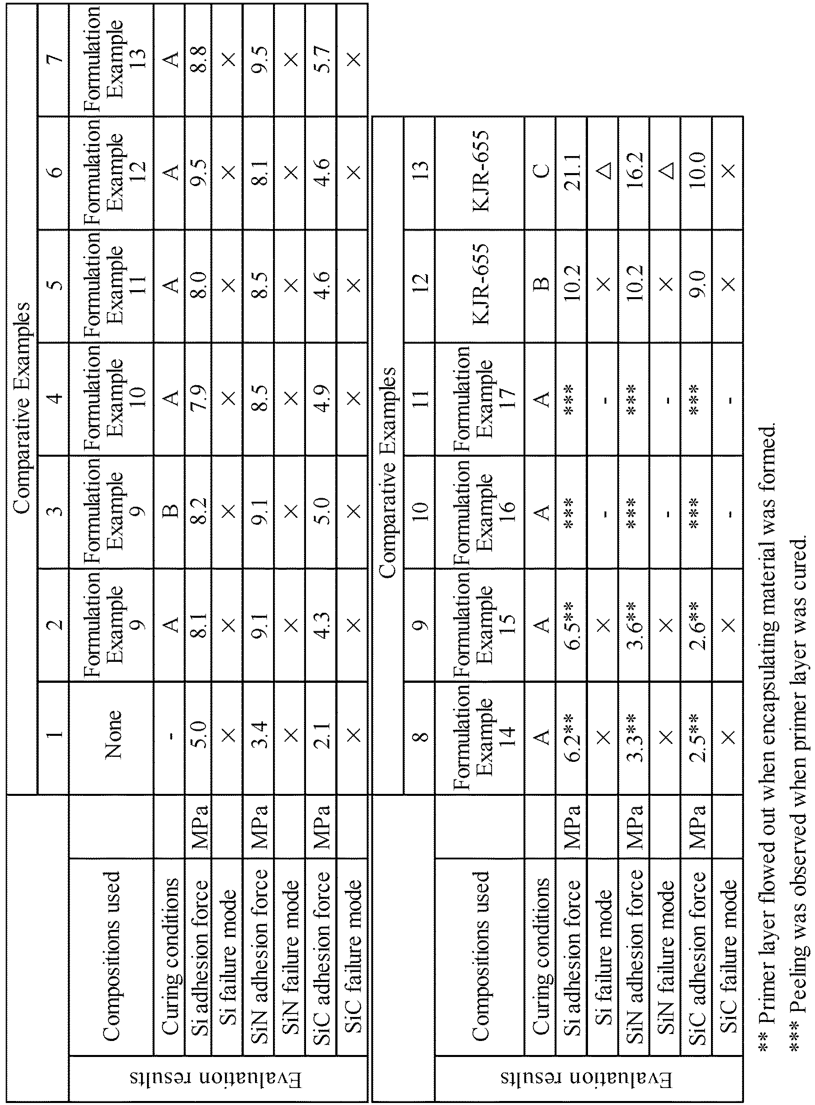

## Claims

1. A curable maleimide resin composition comprising:
(A) a maleimide compound that has a number average molecular weight of 5,000 to 50,000 and is represented by a formula (1): 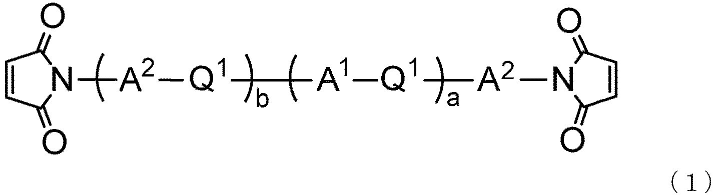 wherein, in the formula (1), Q¹ is independently a divalent group represented by the following formula: 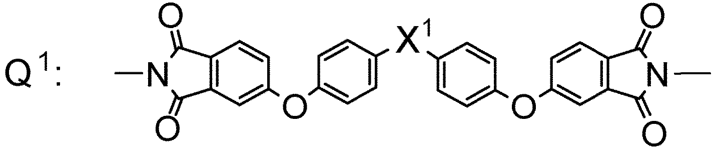 wherein, in the above formula, X¹ is independently a divalent group selected from the following formulae: 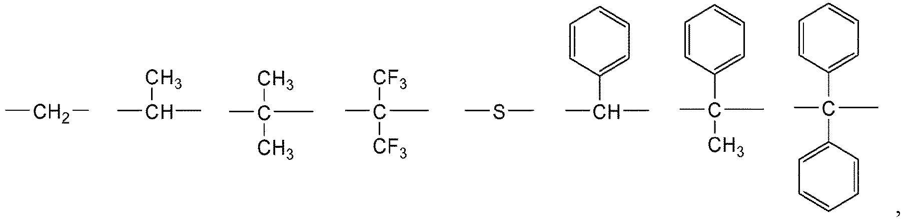 and
wherein, in the formula (1), a is a number of 0 to 50, b is a number of 1 to 50, each of A¹ and A² independently represents a group expressed by a formula (2) or (3): 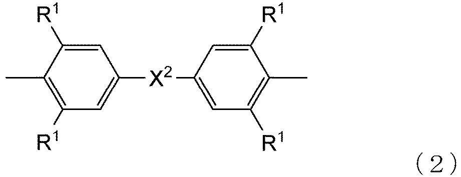 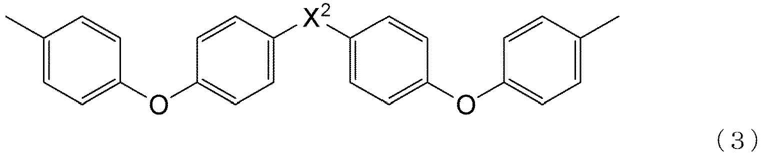 wherein, R¹ in the formula (2) independently represents a hydrogen atom, a chlorine atom, or a substituted or unsubstituted aliphatic hydrocarbon group having 1 to 6 carbon atoms, and X² in the formulae (2) and (3) represents a divalent group selected from groups expressed by the following formulae: 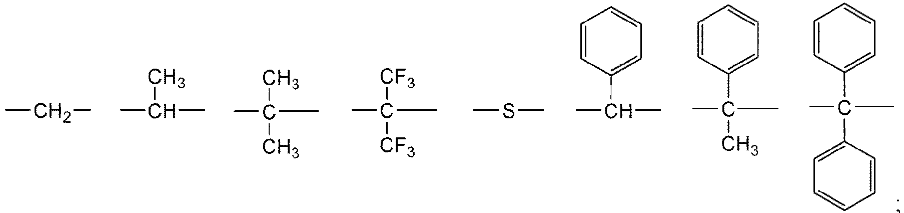
(B) a reaction initiator; and
(C) a silane coupling agent having one or more epoxy groups in one molecule.

2. The curable maleimide resin composition according to claim 1, further comprising (D) a diaminotriazine ring-containing imidazole.

3. The curable maleimide resin composition according to claim 1, further comprising (E) an organic solvent with the proviso that the organic solvent (E) does not comprise N-methylpyrrolidone (NMP).

4. The curable maleimide resin composition according to claim 1, wherein the reaction initiator (B) is an organic peroxide having a one-hour half-life temperature of 150°C or less.

5. An adhesive comprised of the curable maleimide resin composition according to any one of claims 1 to 4.

6. A primer comprised of the curable maleimide resin composition according to any one of claims 1 to 4.

7. A chip coating agent comprised of the curable maleimide resin composition according to any one of claims 1 to 4.

8. A semiconductor device having a cured product of the curable maleimide resin composition according to any one of claims 1 to 4.
